# FASCICULE DE BREVET EUROPEEN

(11) **EP 1 695 157 B1**
(45) Date de publication et mention de la délivrance du brevet: **28.09.2011**
(21) Numéro de dépôt: 04816396.8
(22) Date de dépôt: 16.12.2004
(51) Int. Cl.: G05B 19/04, D06F 33/02, H02M 7/00

(54) **CONTROLEUR DE MOTEUR ELECTRIQUE POUR APPAREIL ELECTROMENAGER**
ELEKTROMOTORSTEUERUNG FÜR EIN HAUSHALTSGERÄT
ELECTRIC MOTOR CONTROLLER FOR A DOMESTIC APPLIANCE

(30) Priorité: 18.12.2003 FR 0314889
(43) Date de publication de la demande: 30.08.2006
(73) Titulaire: Invensys Appliance Controls S.A., 74160 Archamps (FR)
(72) Inventeur: ROSOLI, Jean Marc, F-74300 Thyez (FR); XARDEL, François, F-74440 Mieussy (FR)
(74) Mandataire: Petraz, Davide Luigi
(86) Numéro de dépôt international: PCT/FR2004/003256
(87) Numéro de publication internationale: WO 2005/062141

(56) Documents cités:
- EP-A- 0 684 692
- DE-A- 10 038 475
- FR-A- 2 816 724
- US-A- 5 473 229

## Description

La présente invention concerne les circuits électroniques pour appareils électroménagers, le domaine principal d'utilisation de l'invention étant celui des machines à laver le linge. Cette invention se rapporte en particulier à une carte électronique équipée d'un contrôleur pour moteur asynchrone triphasé ou d'un hacheur pour moteur universel.

Les types de motorisations électriques nouvellement utilisées dans ce domaine, telles que moteur asynchrone triphasé, nécessitent un contrôle plus complexe que les moteurs électriques universels ou les moteurs asynchrones monophasés traditionnellement utilisés pour les appareils électroménagers. En général, on a recours à une carte électronique distincte de celle du programmateur, et dédiée à cette nouvelle exigence de contrôle du moteur, ce qui pose des problèmes complexes d'interfaçage des deux cartes électroniques avec la nécessité de pouvoir modifier et adapter de façon importante ces cartes électroniques pour leur communication.

Afin d'éviter ces inconvénients, on peut choisir de réunir les deux fonctions de programmateur et de contrôle du moteur sur une seule et même carte électronique, ce qui peut permettre, puisque dans ce cas on ne fait appel qu'à un seule carte au lieu de deux, de réduire les coûts correspondants et de simplifier l'alimentation.

Cependant, les deux fonctions de programmateur et de contrôle du moteur ne peuvent pas être référencées aux mêmes potentiels. En effet, la carte du programmateur électronique est habituellement référencée au potentiel neutre pour pouvoir commander les triacs de commande de charges, tandis que la carte de contrôle du moteur est placée après un pont de diodes redresseur et est donc référencée au potentiel neutre mais aussi à la phase, alternativement.

Pour faire communiquer ces deux fonctions de programmateur et de contrôle du moteur, il est donc nécessaire d'isoler électriquement la communication. Il faut aussi nécessairement un microcontrôleur pour chacune de ces deux fonctions et référencé à la référence de la fonction. Plus particulièrement, le microcontrôleur de programmateur doit être référencé au potentiel neutre, tandis que le microcontrôleur de contrôle du moteur est référencé au potentiel "zéro" du pont de diodes du redresseur, chaque microcontrôleur ayant une alimentation distincte.

Afin de s'affranchir de ces contraintes, il a déjà été proposé de déplacer l'isolation optique de la communication, de telle sorte que les deux fonctions soient référencées au même potentiel.

Sur ce principe, une solution connue consiste à référencer ces deux fonctions au potentiel neutre. Dans ce cas, il est nécessaire de placer l'isolation optique au niveau de la partie puissance du contrôle du moteur. Cependant, l'isolation optique est plus contraignante au niveau de la partie puissance du contrôle du moteur, car les fréquences des signaux sont élevées (de 16 à 24 kHz) et les retards induits par l'isolation doivent être faibles. C'est pourquoi les composants capables d'assurer cette fonction sont onéreux. De plus, étant donné que la partie puissance de contrôle du moteur est isolée du microcontrôleur, celui-ci ne peut pas effectuer directement, sur la partie puissance de contrôle du moteur, les mesures de courant ou de tension nécessaires au contrôle. Cette solution est donc coûteuse et ne s'adapte pas à tous les contrôles de moteur.

Le document US 5473229 illustre partiellement cet état de la technique, en montrant une isolation optique située au niveau de la partie puissance d'un moteur électrique, entre une interface avec microprocesseur et un autre microprocesseur.

Le document FR 2816724 divulgue un autre dispositif d'interface pour la commande d'un moteur électrique, le dispositif réalisant l'interfaçage entre un programmateur électronique et une commande de moteur électrique, notamment pour une machine à laver le linge avec programmateur. Toutefois ce dispositif ne comporte aucune isolation optique.

La présente invention vise à éviter ces inconvénients en proposant une solution simple et économique selon le principe général de déplacement de l'isolation optique de la communication, de telle sorte que les deux fonctions soient référencées au même potentiel.

A cet effet, l'invention a essentiellement pour objet un contrôleur de moteur électrique asynchrone triphasé ou de hacheur pour moteur universel, comportant des organes de puissance, tels que des triacs ou des relais, pour la commande de charges, caractérisé en ce que les organes de puissance autres que les relais sont commandés par l'intermédiaire d'un moyen d'isolation, par au moins un microcontrôleur assurant la fonction de programmateur électronique et, par l'intermédiaire d'une commande, la fonction de contrôle de

Ainsi, l'idée inventive consiste à déplacer l'isolation optique de la communication "programmateur - contrôle moteur" vers les triacs de commande de charges, et à référencer les deux fonctions au potentiel "zéro" du pont de diodes du bloc de redressement.

Le moyen d'isolation peut être un moyen optique du type optotriac ou optocoupleur, ou encore un moyen électromagnétique du type relais ou transformateur. Dans le cas des optocoupleurs, il faut prévoir une alimentation isolée pour l'énergie de commande des triacs.

L'énergie basse tension nécessaire aux microcontrôleurs peut être fournie par une seule et même alimentation.

L'alimentation des microcontrôleurs peut ainsi être très simple et alimenter aussi une carte interface avec l'utilisateur.

Dans l'ensemble, la solution fournie par la présente invention propose un dispositif simple et économique pour le contrôle de moteurs notamment asynchrones triphasés, ce qui représente un atout considérable dans un contexte industriel et commercial où il convient de s'adapter rapidement aux nouveaux besoins.

L'invention sera mieux comprise à l'aide de la description qui suit, en référence au dessin schématique annexé représentant, à titre d'exemple, une forme d'exécution de ce contrôleur de moteur électrique.
Figure 1 est un schéma de principe d'une solution actuelle, avec isolation électrique au niveau de la communication ;
Figure 2 est un schéma de principe de la solution objet de la presente invention, avec la commande des charges isolée optiquement ;
Figure 3 est une vue partielle schematique d'un exemple de realisation de l'invention appliqué à une machine à laver le linge.

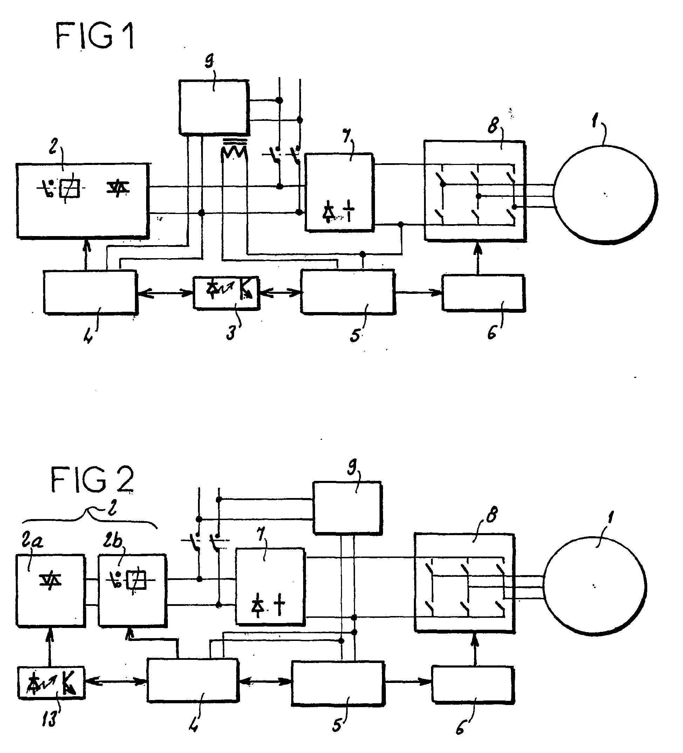

La figure 1 illustre l'état de la technique exposé plus haut. Elle représente un moteur electrique asynchrone triphasé 1 et son contrôleur, ainsi que des organes de puissance 2, tels que des triacs ou des relais, pour la commande de charges. Les organes de puissance 2 sont commandés par un premier microcontrôleur 4 constituant un programmateur électronique. Un second microcontrôleur 5 assure le contrôle du moteur 1 par l'intermédiaire d'une commande 6. Une alimentation basse tension 9 alimente le premier microcontrôleur 4, l'alimentation du second microcontrôleur 5 étant assurée par une alimentation séparée.

Des optocoupleurs 3 isolent ici la communication entre le premier microcontrôleur 4 référencé au potentiel neutre et le second microcontrôleur 5 référencé au potentiel "zéro" d'un bloc 7 de redressement et de filtrage qui alimente le moteur 1 par l'intermédiaire d'un onduleur 8.

La figure 2, sur laquelle les éléments correspondant à ceux précédemment décrits sont désignés par les mêmes repères numériques, indique dans son principe la solution proposée par la présente invention.

Cette figure représente encore un moteur électrique asynchrone triphasé 1, et son contrôleur, ainsi que des organes de puissance 2, tels que des triacs 2a ou des relais 2b, pour la commande de charges. Parmi ces organes de puissance 2, les triacs 2a sont commandés par le premier microcontrôleur 4, constituant programmateur électronique, par l'intermédiaire d'un optotriac 13 ; les relais 2b, isolés par eux-mêmes, sont commandés directement par le premier microcontrôleur 4. Un second microcontrôleur 5 assure le contrôle du moteur 1 par l'intermédiaire d'une commande 6.

Les deux microcontrôleurs 4 et 5 sont référencés au potentiel "zéro" d'un bloc 7 de redressement et de filtrage qui alimente le moteur 1 par l'intermédiaire d'un onduleur 8.

L'énergie basse tension nécessaire aux deux microcontrôleurs 4 et 5 est fournie par une seule et même alimentation basse tension 9, qui alimente également une carte d'interface avec l'utilisateur (non représentée).

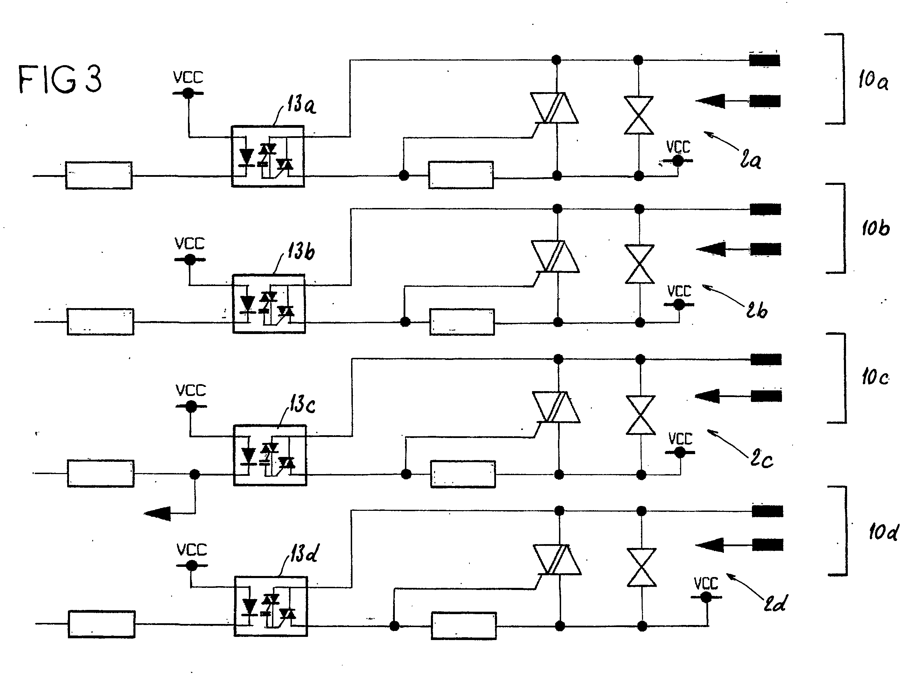

La figure 3 est une vue partielle schématique d'un exemple de réalisation appliqué à une machine à laver le linge, pour la commande d'un moteur électrique 1 d'entraînement en rotation du tambour de cette machine à laver.

Cette figure représente quatre ensembles 2a, 2b, 2c, 2d de commande de charges composés de triacs, pour des électrovannes d'eau chaude 10a et d'eau froide 10b, une pompe de vidange 10c et une distribution 10d de produit Chaque ensemble de commande de charges est isolé par un optotriac 13a, 13b 13c, 13d.

Il est a noter que dans le cas de faibles charges, de l'ordre de 100mA, il est possible d'utiliser l'optotriac 13a, 13b, 13c, 13d seul pour commander directement la charge correspondante

Plus la machine à laver est sophistiquée, plus le nombre de triacs peut être important, par exemple pour la pompe de vidange, la pompe de recirculation, pour les électrovannes de prélavage, de lavage, pour le verrouillage de porte, etc... ce qui signifie que le surcoût dû à l'isolation optique n'est fonction que des options souhaitées et sera proportionnel au niveau de gamme de la machine.

L'on ne s'éloignerait pas du cadre de l'invention, telle que définie dans les revendications annexées :
- en réunissant les fonctions de contrôle de commande du moteur et de programmateur sur un microcontrôleur unique ;
- en utilisant tous types de composants électroniques pour la réalisation des fonctions du dispositif ;
- en appliquant le dispositif à la commande programmée de moteurs électriques de tous types, en particulier pour un hacheur de moteur universel ;
- en destinant le dispositif à d'autres appareils électroménagers à moteur électrique, tels que lave-vaisselle, sèche-linge, réfrigérateur, congélateur, etc...

## Revendications

1. Contrôleur de moteur électrique asynchrone triphasé (1) ou de hacheur pour moteur universel, pour appareils électroménagers, comportant des organes de puissance (2) tels que des triacs (2a) ou des relais (2b), pour la commande de charges, **caractérisé en ce que** les organes de puissance (2, 2a) autres que les relais (2b) sont commandés par l'intermédiaire d'un moyen d'isolation (13), par au moins un microcontrôleur (4, 5) assurant la fonction de programmateur électronique et, par l'intermédiaire d'une commande (6), la fonction de contrôle de commande du moteur (1), ledit microcontrôleur (4, 5) étant référencé au potentiel zéro d'un bloc (7) de redressement et de filtrage qui alimente le moteur (1).

2. Contrôleur selon la revendication 1, **caractérisé en ce que** le moyen d'isolation (13) est un moyen optique du type optotriac ou optocoupleur.

3. Contrôleur selon la revendication 1, **caractérisé en ce que** le moyen d'isolation est un moyen électromagnétique, du type relais ou transformateur.

4. Contrôleur selon l'une quelconque des revendications 1 à 3, **caractérisé en ce que** l'énergie basse tension nécessaire aux microcontrôleurs (4, 5) est fournie par une seule et même alimentation (9).

5. Contrôleur selon la revendication 4, **caractérisé en ce que** l'alimentation basse tension (9) des microcontrôleurs (4, 5) alimente également une carte d'interface avec l'utilisateur.

6. Utilisation du contrôleur selon l'une quelconque des revendications 1 à 5, dans une machine à laver le linge, pour la commande d'un moteur électrique (1) d'entraînement en rotation du tambour de cette machine à laver.

## Claims

1. Controller for a three-phase asynchronous motor (1) or a universal motor actuator, for household appliances, including power elements (2) such as TRIACs (2a) or relays (2b) to control loads, **characterised in that** the power elements (2, 2a) other than the relays (2b) are controlled through an insulation means (13) by at least one microcontroller (4, 5) in charge of the electronic programming function and, through a control (6), of the monitoring control function for the motor (1), said microcontroller (4, 5) being referenced to the zero potential of a recovery and filtering unit (7) that powers the motor (1).

2. Controller according to claim 1, **characterised in that** the insulation means (13) is an optical means of the opto-TRIAC or opto-caupler type.

3. Controller according to claim 1, **characterised in that** the insulation means is an electromagnetic means, such as a relay or a transformer.

4. Controller according to any one of the claims 1 to 3, **characterised in that** the low-voltage energy required by the microcontrollers (4, 5) is supplied by the same single power source (9).

5. Controller according to claim 4, **characterised in that** the low-voltage supply (9) for the microcontrollers (4, 5) also powers a user interface card.

6. Use of the controller according to any one of the claims 1 to 5 in a clothes washing machine to control an electric motor (1) in order to drive the rotation of the drum of said washing machine.

## Patentansprüche

1. Überwachungsgerät eines Drehstrom-Asynchronelektromotors (1) oder eines Verteilers für Universalmotor, für Elektro-Haushaltsgeräte, das Leistungselemente (2) wie Triac (2a) oder Relais (2b) zur Steuerung der Lasten aufweist, **dadurch gekennzeichnet, daß** die Leistungselemente (2, 2a), die verschieden von den Relais (2b) sind, durch ein Isolationsmittel (13) gesteuert sind, und zwar durch mindestens ein Mikroüberwachungsgerät (4, 5), welches die Tätigkeit einer elektronischen Programmiereinheit und durch eine Steuerung (6) die Überwachungstätigkeit der Steuerung des Motors (1) sichert, wobei dieses mikroüberwachungsgerät (4, 5) mit dem Nullpotential einer Gleichrichtungs- und Filtriervorrichtung (7) zur Speisung des Motors (1) in Verbindung gestellt ist.

2. Überwachungsgerät nach Anspruch 1, **dadurch gekennzeichnet, daß** das Isoliermittel (13) ein optisches Mittel ähnlich wie ein Optotriac oder ein Optokoppler ist.

3. Überwachungsgerät nach Anspruch 1, **dadurch gekennzeichnet, daß** das Isoliermittel ein elektromagnetisches Mittel ähnlich wie ein Relais oder ein Transformator ist.

4. Überwachungsgerät nach dem einen oder dem anderen der Ansprüche 1 bis 3, **dadurch gekennzeichnet, daß** die für die Mikroüberwachungsgeräte (4, 5) erforderliche Niederspannungsenergie durch die gleiche und einzige Speisequelle (9) gespeist ist.

5. Überwachungsgerät nach Anspruch 4, **dadurch gekennzeichnet, daß** die Speisequelle (9), die die Niederspannung für das Mikroüberwachungsgerät (4, 5) speist, einen Schnittstellenbaustein mit dem Verbraucher ebenfalls speist.

6. Verwendung des Überwachungsgeräts nach dem einen oder dem anderen der Ansprüche 1 bis 5, in einer Waschmaschine, zur Steuerung eines Elektromotors (1), welcher die Drehung der Trommel dieser Waschmaschine antreibt.
